# EUROPÄISCHE PATENTANMELDUNG

(11) **EP 4 009 025 A1**
(43) Veröffentlichungstag der Anmeldung: **08.06.2022**
(21) Anmeldenummer: 20212258.6
(22) Anmeldetag: 07.12.2020
(51) Int. Cl.: G01K 7/18, H01L 23/34, H01L 25/07, H01H 37/76, G01K 7/00, G01R 1/20, H01B 1/02

(54) **BONDVERBINDUNGSMITTEL AUFWEISEND EINEN KERN UND UMHÜLLENDEN MANTEL**

(71) Anmelder: Siemens Aktiengesellschaft, 80333 München (DE)
(72) Erfinder: Kneißl, Philipp, 90427 Nürnberg (DE); Zeyß, Felix, 93059 Regensburg (DE); Pfeifer, Markus, 90455 Nürnberg (DE)

(57) **Zusammenfassung**

Die Erfindung betrifft ein Bondverbindungsmittel (2) zur Verbindung eines Halbleiterelements (10) mit einem Substrat (12). Um eine Optimierung des Layouts zu ermöglichen, wird vorgeschlagen, dass das Bondverbindungsmittel (2) einen Kern (4) und einen den Kern (4), insbesondere vollständig, umhüllenden Mantel (6) aufweist, wobei der Kern (4) aus einem ersten metallischen Werkstoff und der Mantel (6) aus einem vom ersten metallischen Werkstoff verschiedenen zweiten metallischen Werkstoff hergestellt ist und wobei der erste metallische Werkstoff des Kerns (4) eine niedrigere elektrische Leitfähigkeit aufweist als der zweite metallische Werkstoff des Mantels (6).

## Beschreibung

Die Erfindung betrifft ein Bondverbindungsmittel zur Verbindung eines Halbleiterelements mit einem Substrat.

Ferner betrifft die Erfindung ein Halbleitermodul mit mindestens einem Halbleiterelement, einem Substrat und zumindest einem derartigen Bondverbindungsmittel.

Zudem betrifft die Erfindung einen Stromrichter mit mindestens einem Halbleitermodul.

Überdies betrifft die Erfindung eine Verwendung zumindest eines Bondverbindungsmittels als Gatewiderstand, als Shunt, als Widerstand in einem RC-Filter, oder als Schmelzsicherung in einem Halbleitermodul.

Darüber hinaus betrifft die Erfindung eine Verwendung zumindest eines Bondverbindungsmittels zur Strommessung oder Temperaturermittlung in einem Halbleitermodul.

In derartigen Stromrichtern werden in der Regel Bondverbindungsmittel, welche beispielsweise als Bonddrähte oder Bondbänder ausgeführt sind, lediglich zur Verbindung eines Halbleiterelements mit einem Substrat in einem Halbleitermodul eingesetzt. Unter einem Stromrichter ist beispielsweise ein Gleichrichter, ein Wechselrichter, ein Umrichter oder ein Gleichspannungswandler zu verstehen. Daher stehen bei derartigen Bondverbindungsmitteln in der Regel die Verringerung von parasitären Widerständen und parasitären Induktivitäten im Fokus.

Die Patentschrift DE 10 2010 031 993 B4 beschreibt ein Verfahren zur Herstellung eines Bonddrahtes aufweisend einen Drahtkern aus einem ersten Material und einen den Drahtkern umhüllenden Drahtmantel aus einem zweiten Material, wobei das erste Material ein erstes Metall und das zweite Material ein zweites Metall aufweist und das erste Metall und das zweite Metall verschieden sind.

Die Patentschrift EP 2 662 891 B1 beschreibt ein Verfahren zur Herstellung eines aluminiumbeschichteten Kupferbonddrahtes.

In einem Halbleitermodul benötigte definierte Widerstände, welche beispielsweise für eine Ansteuerung eines Halbleiterelements oder für die Erfassung eines Stromwertes, sogenannte Shuntwiderstände, benötigt werden, werden beispielsweise als externe Widerstände realisiert, welche zusätzlichen Bauraum erfordern. Alternativ sind beispielsweise Shuntwiderstände als interne Bauteile, welche im Halbleiterelement integriert sind, ausgeführt, wobei derartige interne Bauteile insbesondere eine geringe Strombelastbarkeit, einen hohen Temperaturdrift und hohe Kosten für den Bauraum auf dem Chip aufweisen.

Vor diesem Hintergrund ist es eine Aufgabe der vorliegenden Erfindung, ein Bondverbindungsmittel zur Verbindung eines Halbleiterelements mit einem Substrat anzugeben, welches eine Optimierung des Layouts ermöglicht.

Die Aufgabe wird erfindungsgemäß gelöst durch ein Bondverbindungsmittel zur Verbindung eines Halbleiterelements mit einem Substrat, aufweisend einen Kern und einen den Kern, insbesondere vollständig, umhüllenden Mantel, wobei der Kern aus einem ersten metallischen Werkstoff und der Mantel aus einem vom ersten metallischen Werkstoff verschiedenen zweiten metallischen Werkstoff hergestellt ist und wobei der erste metallische Werkstoff des Kerns eine niedrigere elektrische Leitfähigkeit aufweist als der zweite metallische Werkstoff des Mantels.

Ferner wird die Aufgabe erfindungsgemäß gelöst durch ein Halbleitermodul mit mindestens einem Halbleiterelement, einem Substrat und zumindest einem derartigen Bondverbindungsmittel, wobei das Halbleiterelement und/oder das Substrat mit dem zumindest einem Bondverbindungsmittel verbunden sind.

Zudem wird die Aufgabe erfindungsgemäß durch einen Stromrichter mit mindestens einem Halbleitermodul gelöst.

Überdies wird die Aufgabe erfindungsgemäß gelöst durch die Verwendung zumindest eines Bondverbindungsmittels als Gatewiderstand, als Shunt, als Widerstand in einem RC-Filter, oder als Schmelzsicherung in einem Halbleitermodul, wobei das zumindest eine Bondverbindungsmittel einen Kern und einen den Kern, insbesondere vollständig, umhüllenden Mantel aufweist, wobei der Kern aus einem ersten metallischen Werkstoff und der Mantel aus einem vom ersten metallischen Werkstoff verschiedenen zweiten metallischen Werkstoff hergestellt ist und wobei der erste metallische Werkstoff des Kerns eine niedrigere elektrische Leitfähigkeit aufweist als der zweite metallische Werkstoff des Mantels.

Darüber hinaus wird die Aufgabe erfindungsgemäß gelöst durch die Verwendung zumindest eines Bondverbindungsmittels zur Strommessung oder Temperaturermittlung in einem Halbleitermodul, wobei das zumindest eine Bondverbindungsmittel einen Kern und einen den Kern, insbesondere vollständig, umhüllenden Mantel aufweist, wobei der Kern aus einem ersten metallischen Werkstoff und der Mantel aus einem vom ersten metallischen Werkstoff verschiedenen zweiten metallischen Werkstoff hergestellt ist und wobei der erste metallische Werkstoff des Kerns eine niedrigere elektrische Leitfähigkeit aufweist als der zweite metallische Werkstoff des Mantels.

Die in Bezug auf das Bondverbindungsmittel nachstehend angeführten Vorteile und bevorzugten Ausgestaltungen lassen sich sinngemäß auf das Halbleitermodul, den Stromrichter und die Verwendungen übertragen.

Der Erfindung liegt die Überlegung zugrunde, ein Layout eines Halbleitermoduls zu optimieren, indem ein vorhandenes Bondverbindungsmittel als Widerstand verwendet wird und beispielsweise einen externen Widerstand ersetzt, wodurch Bauraum eingespart wird. Ein derartiges Bondverbindungsmittel ist beispielsweise als Bonddraht oder Bondband ausgeführt und weist einen Kern und einen den Kern, insbesondere vollständig, umhüllenden Mantel auf, wobei der Kern aus einem ersten metallischen Werkstoff und der Mantel aus einem vom ersten metallischen Werkstoff verschiedenen zweiten metallischen Werkstoff hergestellt ist. Der zweite metallische Werkstoff des Mantels, der auch Mantelmaterial oder Basismaterial genannt wird, ist insbesondere dafür geeignet, durch Ultraschallschweißen, beispielsweise durch Ultraschallreibschweißen, mit einer Oberfläche, z.B. des Substrats und/oder des Halbleiterelements, verbunden zu werden. Beispielsweise enthält das Mantelmaterial Aluminium, Kupfer oder Gold. Der erste metallische Werkstoff des Kerns weist eine niedrigere elektrische Leitfähigkeit auf als der zweite metallische Werkstoff des Mantels. Insbesondere enthält der erste metallische Werkstoff des Kerns eine Widerstandslegierung, wodurch ein großer Widerstand mit einer kurzen Bonddrahtlänge herstellbar ist, wodurch sich beispielsweise eine parasitäre Induktivität reduziert. Durch das Ersetzen eines diskreten externen Bauteils, wie beispielsweise eines Gatewiderstands, eines Shuntwiderstands oder eines Widerstands in einem RC-Filter, durch derartige, insbesondere bereits vorhandene, Bondverbindungsmittel wird Bauraum eingespart und eine Optimierung des Layouts ermöglicht. Ferner ist kein zusätzlicher Prozessschritt erforderlich. Insbesondere ermöglicht das Ersetzen eines diskreten Shuntwiderstands durch, beispielsweise parallel geschaltete, Bondverbindungsmittel wird durch die Platzersparnis eine Einzelstrommessungen für parallele Halbleiterelemente ermöglicht. Eine zusätzliche Platzersparnis wird beispielsweise erreicht, indem die als Shuntwiderstand ausgeführten Bondverbindungsmittel andere, insbesondere auf dem Substrat strukturiert aufgebrachte, Leiter überspannen. Dies ermöglicht darüber hinaus eine noch größere Freiheit bei der Optimierung des Layouts. Ferner ermöglicht die Verwendung eines derartigen Bondverbindungsmittels eine Strommessung oder eine Temperaturermittlung. Eine Strommessung erfolgt beispielsweise indem ein Spannungsabfall an einem von einem Strom durchflossenen Bondverbindungsmittel gemessen wird, wobei aufgrund des bekannten Widerstands des Bondverbindungsmittels der Strom durch das Bondverbindungsmittel ermittelbar ist. Eine Temperaturermittlung erfolgt beispielsweise indem der Spannungsabfall an einem von einem definierten Strom durchflossenen Bondverbindungsmittel gemessen und daraus mittels eines materialspezifischen Umrechnungsfaktors eine Temperatur ermittelt wird.

Eine weitere Ausführungsform sieht vor, dass die elektrische Leitfähigkeit des ersten metallischen Werkstoffs maximal 10 %, insbesondere maximal 5 %, der elektrischen Leitfähigkeit des zweiten metallischen Werkstoffs beträgt. Dies ist vorteilhaft, da ein Widerstand des Bondverbindungsmittels definiert über einen breiten Bereich variierbar ist.

Eine weitere Ausführungsform sieht vor, dass der erste metallische Werkstoff des Kerns eine Leitfähigkeit im Bereich von 0,5 MS/m bis 20 MS/m, insbesondere im Bereich von 0,5 MS/m bis 4 MS/m, aufweist. Mit derartigen Leitfähigkeiten sind vergleichsweise hohe definierte Widerstände mit kurzen Bonddrähten realisierbar.

Eine weitere Ausführungsform sieht vor, dass der Widerstand des ersten metallischen Werkstoffs des Kerns einen Temperaturkoeffizienten von ±0,1 · 10⁻³ K⁻¹ im Bereich von -40°C bis 200°C aufweist. Ein derartig flacher Temperaturkoeffizient ermöglicht die Realisierung eines definierten Widerstands über einen großen Temperaturbereich.

Eine weitere Ausführungsform sieht vor, dass der Kern Zeranin, Manganin, Konstantan oder Isaohm enthält. Derartige Widerstandslegierungen ermöglichen durch ihren flachen Temperaturkoeffizienten die Realisierung eines definierten Widerstands über einen großen Temperaturbereich.

Eine weitere Ausführungsform sieht vor, dass der Kern einen Kaltleiter enthält. Insbesondere ist der Kern aus Platin hergestellt. Bondverbindungsmittel mit einem derartigen Kern sind zur Temperaturmessung geeignet.

Eine weitere Ausführungsform sieht vor, dass der erste metallische Werkstoff des Kerns einen Widerstand mit einem im Wesentlichen linearen Temperaturverlauf aufweist. Ein linearer Temperaturverlauf des Widerstands liegt insbesondere vor, wenn ein Temperaturkoeffizient zweiter und/oder dritter Ordnung mindestens 100x, insbesondere 500x, kleiner als ein Temperaturkoeffizient erster Ordnung ist. Beispielsweise ist der Kern aus Resistherm (NiFe30) hergestellt. Durch einen derartig ausgeführten Kern ist ein Bondverbindungsmittel herstellbar, dessen Widerstand durch die Länge und/oder Querschnittsgeometrie einstellbar und definiert ist, wobei der Widerstand von der Temperatur des Bondverbindungsmittels abhängig ist.

Eine weitere Ausführungsform sieht vor, dass ein Flächenanteil des Kerns mindestens 90 % der Querschnittsfläche des Bondverbindungsmittels beträgt. Dies ist vorteilhaft, da ein Widerstand des Bondverbindungsmittels definiert über einen breiten Bereich variierbar ist.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Bondverbindungsmittels,
- FIG 2: eine schematische Darstellung eines Halbleitermoduls mit parallelen Halbleiterelementen und als Gatewiderstände ausgeführten Bondverbindungsmitteln,
- FIG 3: eine schematische Darstellung eines Halbleitermoduls mit einem RC-Filter,
- FIG 4: eine schematische Darstellung eines Halbleitermoduls mit als Shuntwiderstand ausgeführten Bondverbindungsmitteln,
- FIG 5: eine schematische Darstellung von parallelen Halbleiterelementen mit Bondverbindungsmitteln im Laststrompfad,
- FIG 6: eine schematische Darstellung von parallelen Halbleiterelementen mit Bondverbindungsmitteln im Gatepfad und
- FIG 7: eine schematische Darstellung einer zweiten Ausgestaltung eines Bondverbindungsmittels.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

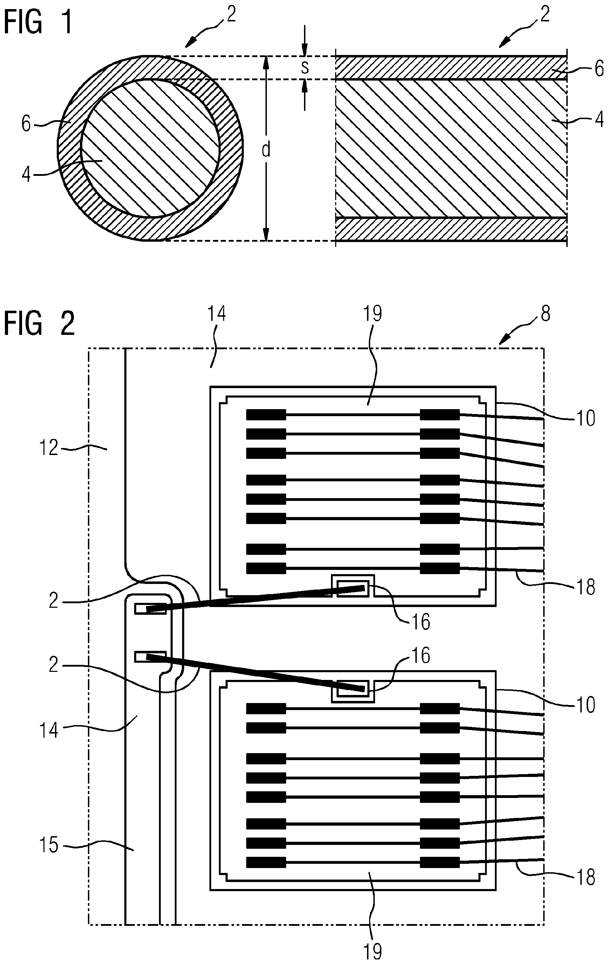

FIG 1 zeigt eine schematische Darstellung einer ersten Ausgestaltung eines Bondverbindungsmittels 2, welches beispielhaft als Bonddraht mit einem kreisförmigen Querschnitt ausgeführt ist. Während links ein Querschnitt des Bonddrahts dargestellt ist, ist rechts ein Längsschnitt des Bonddrahts abgebildet. Der Bonddraht weist einen Kern 4 und einen den Kern 4 vollständig umhüllenden Mantel 6 auf, wobei der Kern 4 aus einem ersten metallischen Werkstoff und der Mantel 6 aus einem vom ersten metallischen Werkstoff verschiedenen zweiten metallischen Werkstoff hergestellt ist. Ein Flächenanteil des Kerns 4 beträgt mindestens 90 % der Querschnittsfläche des Bonddrahts, wobei ein Durchmesser d des Bonddrahts im Bereich von 125 µm bis 500 µm liegt. Eine Stärke s des Mantels beträgt maximal 15 µm.

Der zweite metallische Werkstoff, der auch Mantelmaterial oder Basismaterial genannt wird, ist konfiguriert eine elektrische leitende Verbindung eines Halbleiterelements zu einer Oberfläche, insbesondere eines Substrats, herzustellen. Eine derartige Bondverbindung wird beispielsweise durch Ultraschallschweißen, insbesondere durch Ultraschallreibschweißen, hergestellt, wobei das Mantelmaterial beispielsweise Aluminium, Kupfer oder Gold enthält. Der erste metallische Werkstoff des Kerns 4 weist eine niedrigere elektrische Leitfähigkeit auf als das Mantelmaterial, wobei die elektrische Leitfähigkeit des ersten metallischen Werkstoffs maximal 10 %, insbesondere maximal 5 %, der elektrischen Leitfähigkeit des Mantelmaterials beträgt. Insbesondere weist der erste metallische Werkstoff des Kerns 4 einen definierten Widerstand auf, wobei die Leitfähigkeit des ersten metallischen Werkstoffs im Bereich von 0,5 MS/m bis 20 MS/m, insbesondere im Bereich von 0,5 MS/m bis 4 MS/m, liegt. Der Bonddraht in FIG 1 ist beispielsweise mittels Drahtziehen herstellbar.

FIG 2 zeigt eine schematische Darstellung eines Halbleitermoduls 8 mit parallelen Halbleiterelementen 10 und als Gatewiderstände ausgeführten Bondverbindungsmitteln 2, welche die parallelen Halbleiterelemente 10 mit einem Substrat 12 verbinden. Insbesondere sind die als Gatewiderstände ausgeführten Bondverbindungsmittel 2 mit einer strukturierten Metallisierung 14 des Substrats 12 verbunden. Beispielhaft sind die Halbleiterelemente 10 jeweils als Transistor, insbesondere als Insulated-Gate-Bipolar-Transistor (IGBT), als Metalloxide-Semiconductor-Field-Effect-Transistor (MOSFET) oder als Feldeffekttransistor, ausgeführt. Eine gemeinsame Zuleitung 15 ist über jeweils ein Bondverbindungsmittel 2 mit einem Gatekontakt 16 des jeweiligen Halbleiterelements 10 verbunden. Weitere Bonddrähte 18 sind zur weiteren Kontaktierung, insbesondere von Emitterkontakten 19, der Halbleiterelemente 10 mit dem Substrat 12 vorgesehen.

Um einen konstanten Widerstand über einen definierten Temperaturbereich zu erreichen ist der Kern 4 des Bondverbindungsmittels 2 aus einer Widerstandslegierung hergestellt. Beispielsweise weist der Widerstand des ersten metallischen Werkstoffs des Kerns 4 einen Temperaturkoeffizienten von ±0,1 ·10⁻³ K⁻¹ im Bereich von -40°C bis 200°C auf. Die Widerstandslegierung enthält beispielsweise Zeranin, Manganin, Konstantan oder Isaohm. Die durch die Bondverbindungsmittel 2 gebildeten Gatewiderstände sind, beispielsweise durch die Länge und/oder Querschnittsgeometrie der Bondverbindungsmittel 2, insbesondere für parallele Halbleiterelemente 10, individuell anpassbar.

Alternativ ist der Kern 4 des Bondverbindungsmittels 2 aus einem Werkstoff mit hohem, insbesondere definierten, Temperaturkoeffizienten hergestellt. Ein derartiger hoher Temperaturkoeffizient liegt im Bereich von 3·10⁻³ K⁻¹ bis 10·10⁻³ K⁻¹ bei 20 C. Insbesondere weist der erste metallische Werkstoff des Kerns 4 einen Widerstand mit einem im Wesentlichen linearen Temperaturverlauf auf. Beispielsweise enthält der Kern 4 einen Kaltleiter wie Platin oder Resistherm (NiFe30). Durch einen derartig ausgeführten Kern 4 ist ein Bondverbindungsmittel 2 herstellbar, dessen Widerstand durch die Länge und/oder Querschnittsgeometrie einstellbar und definiert ist, wobei der Widerstand von der Temperatur des Bondverbindungsmittels 2 abhängig ist. Da sich bei einer Erwärmung des Halbleiterelements 10 auch das als Gatewiderstand ausgeführte Bondverbindungsmittel 2 erwärmt und der Widerstand des Bondverbindungsmittels 2 mit steigender Temperatur steigt, schaltet das Halbleiterelement 10 durch die Stromgegenkopplung langsamer und es kommt zu einer Verringerung des Laststroms. Daher ist durch die Verwendung von Bondverbindungsmitteln 2, welches einen Kern 4 aus einem Werkstoff mit hohem Temperaturkoeffizienten aufweisen, als Gatewiderstände eine Symmetrierung der Lastströme erreichbar. Die weitere Ausführung der Bondverbindungsmittel 2 in FIG 2 entspricht der in FIG 1.

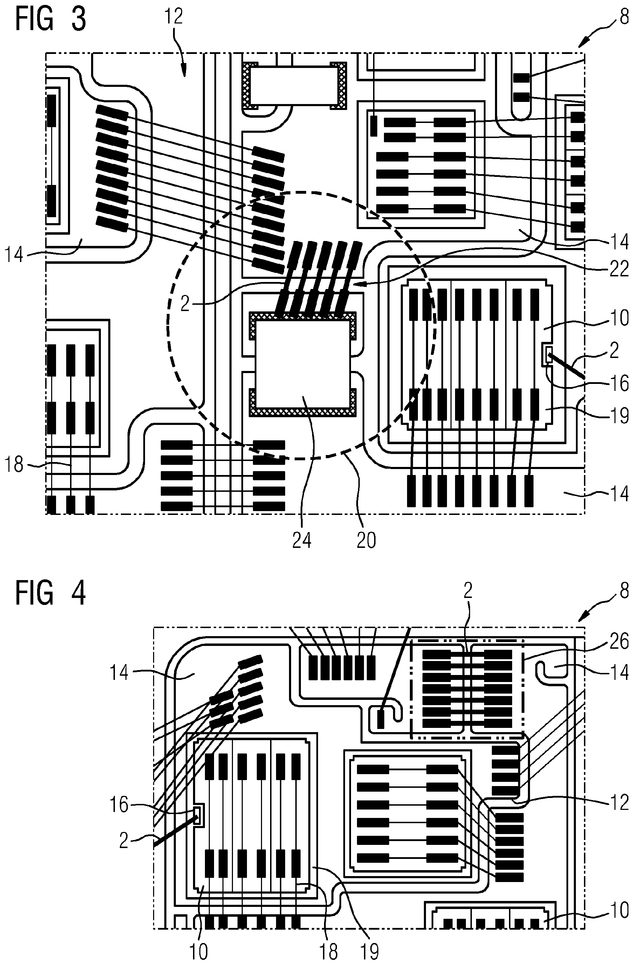

FIG 3 zeigt eine schematische Darstellung eines Halbleitermoduls 8 mit einem RC-Filter 20, wobei ein Widerstand 22 des RC-Filters 20 durch, insbesondere fünf parallele, Bondverbindungsmittel 2 realisiert ist, während eine Kapazität 24 des RC-Filters 20 als Snubber-Kondensator ausgeführt ist. Die weitere Ausführung des Halbleitermoduls 8 und der Bondverbindungsmittel 2 in FIG 3 entspricht der in FIG 2.

FIG 4 zeigt eine schematische Darstellung eines Halbleitermoduls 8 mit als Shuntwiderstand 26 ausgeführten Bondverbindungsmitteln 2. Durch eine derartigen Shuntwiderstand 26 wird Bauraum eigespart, sodass Einzelstrommessungen für parallele Halbleiterelemente 10 platzsparend ermöglicht werden. Ist der Kern 4 der Bondverbindungsmittel 2, wie in FIG 2 beschrieben, aus einem Werkstoff mit hohem, insbesondere definierten, Temperaturkoeffizienten hergestellt. Beispielsweise enthält der Kern 4 einen Kaltleiter wie Platin oder Resistherm (NiFe30). Durch die laststromabhängige Erwärmung der Bondverbindungsmittel 2 ergibt sich eine negative Rückkopplung: Je größer ein durch die Bondverbindungsmittel 2 des Shuntwiderstands 26 fließende Laststrom ist, desto höher dessen Temperatur. Da der Widerstand der Bondverbindungsmittel 2 mit der Temperatur steigt, wird der Laststrom begrenzt. Bei einer Parallelschaltung von Halbleiterelementen 10 ist eine symmetrische Laststromaufteilung optimierbar, wenn der so gebildete Shuntwiderstand 26 in Reihe zu den jeweiligen Halbleiterelementen 10 geschaltet ist. Durch eine thermische Kopplung des Shuntwiderstands 26 an das jeweilige Halbleiterelement 10, beispielsweise durch direktes Bonden des Halbleiterelements 10 mit den Bondverbindungsmitteln 2 des Shuntwiderstands 26, wird die Rückkopplung verstärkt. Die weitere Ausführung des Halbleitermoduls 8 und der Bondverbindungsmittel 2 in FIG 4 entspricht der in FIG 2.

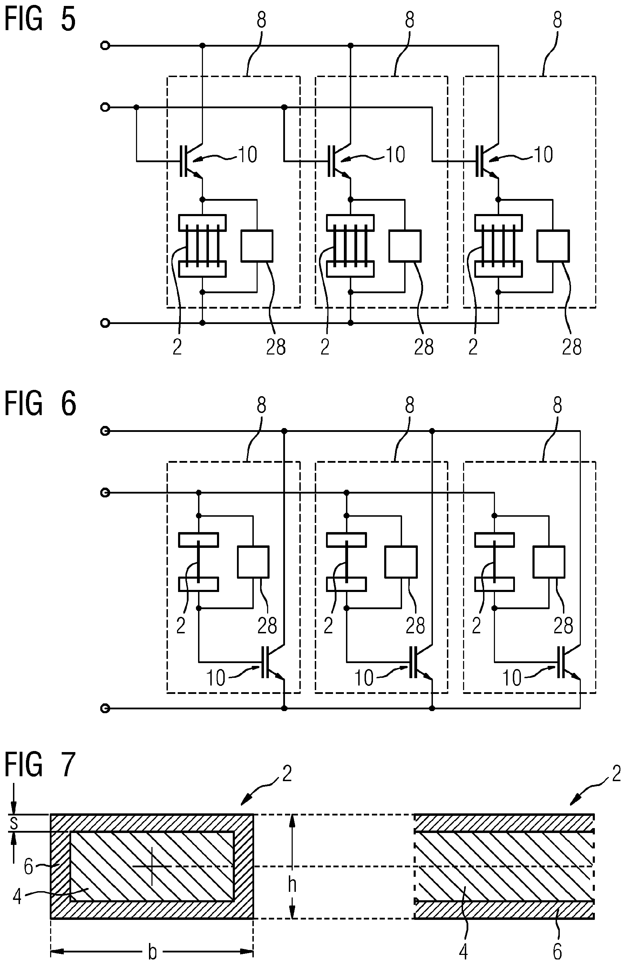

FIG 5 zeigt eine schematische Darstellung von parallelen Halbleiterelementen 10 mit Bondverbindungsmitteln 2 im Laststrompfad, wobei die parallelen Halbleiter auf parallelen Halbleitermodulen 8 angeordnet sind. Der Kern 4 der Bondverbindungsmittel 2 ist, wie in FIG 2 beschrieben, aus einem Werkstoff mit hohem, insbesondere definierten, Temperaturkoeffizienten hergestellt. Beispielsweise enthält der Kern 4 einen Kaltleiter wie Platin oder Resistherm (NiFe30). Somit wird in den Laststrompfaden der parallelen Halbleitermodule 8 jeweils ein temperaturabhängiger Widerstand durch die Bondverbindungsmittel 2 gebildet, was zu einer Symmetrierung über die Halbleitermodule 8 hinweg führt. Eine Temperatur ist bei bekanntem Laststrom mittels Messvorrichtungen 28 ermittelbar. Die Temperaturermittlung erfolgt insbesondere, indem der Spannungsabfall an den Bondverbindungsmitteln 2 bei bekanntem Laststrom gemessen und daraus mittels eines materialspezifischen Umrechnungsfaktors die Temperatur ermittelt wird. Optional sind die Bondverbindungsmittel 2 als Schmelzsicherung ausgeführt, welche sich bei einem hohen Überstrom stark erhitzt und sehr hochohmig wird oder durchbrennt. Die weitere Ausführung der Halbleitermodule 8 und der Bondverbindungsmittel 2 in FIG 5 entspricht der in FIG 2.

FIG 6 zeigt eine schematische Darstellung von parallelen Halbleiterelementen 10 mit Bondverbindungsmitteln 2 im Gatepfad. Analog zu FIG 5 wird in den Gatepfaden der parallelen Halbleitermodule 8 jeweils ein temperaturabhängiger Widerstand durch die Bondverbindungsmittel 2 gebildet, was zu einer Symmetrierung über die Halbleitermodule 8 hinweg führt. Eine Temperatur ist bei bekanntem Gatestrom mittels Messvorrichtungen 28, wie in FIG 5 beschrieben, ermittelbar. Die weitere Ausführung der Halbleitermodule 8 und der Bondverbindungsmittel 2 in FIG 6 entspricht der in FIG 5.

FIG 7 zeigt eine schematische Darstellung einer zweiten Ausgestaltung eines Bondverbindungsmittels 2, welches beispielhaft als Bondband mit einem rechteckigen Querschnitt ausgeführt ist. Während links ein Querschnitt des Bondbands dargestellt ist, ist rechts ein Längsschnitt des Bondbands abgebildet. Analog zu FIG 1 weist das Bondband einen Kern 4 und einen den Kern 4 vollständig umhüllenden Mantel 6 auf, wobei der Kern 4 aus einem ersten metallischen Werkstoff und der Mantel 6 aus einem vom ersten metallischen Werkstoff verschiedenen zweiten metallischen Werkstoff hergestellt ist. Alternativ umhüllt der Mantel 6 des Bondbands den Kern 4 nicht vollständig. Beispielsweise ist der Mantel 6 des Bondbands sandwichartig an gegenüberliegenden längeren Seiten des rechteckigen Querschnitts mit dem Kern 4 verbunden. Die kürzeren Seitenflächen des Bondbands weisen bei jener Ausgestaltung keine Funktion beim Bondprozess auf. Ein Flächenanteil des Kerns 4 beträgt mindestens 90 % der Querschnittsfläche des Bondbands, wobei das Bondband beispielsweise eine Breite b von 4 mm und eine Höhe h von 1 mm aufweist.

Zusammenfassend betrifft die Erfindung ein Bondverbindungsmittel 2 zur Verbindung eines Halbleiterelements 10 mit einem Substrat 12. Um eine Optimierung des Layouts zu ermöglichen, wird vorgeschlagen, dass das Bondverbindungsmittel 2 einen Kern 4 und einen den Kern 4, insbesondere vollständig, umhüllenden Mantel 6 aufweist, wobei der Kern 4 aus einem ersten metallischen Werkstoff und der Mantel 6 aus einem vom ersten metallischen Werkstoff verschiedenen zweiten metallischen Werkstoff hergestellt ist und wobei der erste metallische Werkstoff des Kerns 4 eine niedrigere elektrische Leitfähigkeit aufweist als der zweite metallische Werkstoff des Mantels 6.

## Patentansprüche

1. Bondverbindungsmittel (2) zur Verbindung eines Halbleiterelements (10) mit einem Substrat (12),
aufweisend einen Kern (4) und einen den Kern (4), insbesondere vollständig, umhüllenden Mantel (6),
wobei der Kern (4) aus einem ersten metallischen Werkstoff und der Mantel (6) aus einem vom ersten metallischen Werkstoff verschiedenen zweiten metallischen Werkstoff hergestellt ist und
wobei der erste metallische Werkstoff des Kerns (4) eine niedrigere elektrische Leitfähigkeit aufweist als der zweite metallische Werkstoff des Mantels (6).

2. Bondverbindungsmittel (2) nach Anspruch 1,
wobei die elektrische Leitfähigkeit des ersten metallischen Werkstoffs maximal 10 %, insbesondere maximal 5 %, der elektrischen Leitfähigkeit des zweiten metallischen Werkstoffs beträgt.

3. Bondverbindungsmittel (2) nach einem der Ansprüche 1 oder 2,
wobei der erste metallische Werkstoff des Kerns (4) eine Leitfähigkeit im Bereich von 0,5 MS/m bis 20 MS/m, insbesondere im Bereich von 0,5 MS/m bis 4 MS/m, aufweist.

4. Bondverbindungsmittel (2) nach einem der Ansprüche 1 bis 3,
wobei der Widerstand des ersten metallischen Werkstoffs des Kerns (4) einen Temperaturkoeffizienten von ±0,1·10⁻³ K⁻¹ im Bereich von -40°C bis 200°C aufweist.

5. Bondverbindungsmittel (2) nach einem der vorherigen Ansprüche,
wobei der Kern (4) Zeranin, Manganin, Konstantan oder Isaohm enthält.

6. Bondverbindungsmittel (2) nach einem der Ansprüche 1 bis 3,
wobei der Kern (4) einen Kaltleiter enthält.

7. Bondverbindungsmittel (2) nach einem der Ansprüche 1 bis 3 oder 6,
wobei der erste metallische Werkstoff des Kerns (4) einen Widerstand mit einem im Wesentlichen linearen Temperaturverlauf aufweist.

8. Bondverbindungsmittel (2) nach einem der vorherigen Ansprüche,
wobei ein Flächenanteil des Kerns (4) mindestens 90 % der Querschnittsfläche des Bondverbindungsmittels (2) beträgt.

9. Halbleitermodul (8) mit mindestens einem Halbleiterelement (10), einem Substrat (12) und zumindest einem Bondverbindungsmittel (2) nach einem der vorherigen Ansprüche,
wobei das Halbleiterelement (10) und/oder das Substrat (12) mit dem zumindest einem Bondverbindungsmittel (2) verbunden sind.

10. Halbleitermodul (8) nach Anspruch 9,
wobei zumindest ein Bondverbindungsmittel (2) als Gatewiderstand, als Shunt, als Widerstand in einem RC-Filter oder als Schmelzsicherung konfiguriert ist.

11. Halbleitermodul (8) nach einem der Ansprüche 9 oder 10,
wobei zumindest ein Bondverbindungsmittel (2) zur Strommessung konfiguriert ist.

12. Halbleitermodul (8) nach einem der Ansprüche 9 bis 11,
wobei zumindest ein Bondverbindungsmittel (2) zur Temperaturermittlung konfiguriert ist.

13. Stromrichter mit mindestens einem Halbleitermodul (8) nach einem der vorherigen Ansprüche.

14. Verwendung zumindest eines Bondverbindungsmittels (2) als Gatewiderstand, als Shunt, als Widerstand in einem RC-Filter, oder als Schmelzsicherung in einem Halbleitermodul (8),
wobei das zumindest eine Bondverbindungsmittel (2) einen Kern (4) und einen den Kern (4), insbesondere vollständig, umhüllenden Mantel (6) aufweist,
wobei der Kern (4) aus einem ersten metallischen Werkstoff und der Mantel (6) aus einem vom ersten metallischen Werkstoff verschiedenen zweiten metallischen Werkstoff hergestellt ist und
wobei der erste metallische Werkstoff des Kerns (4) eine niedrigere elektrische Leitfähigkeit aufweist als der zweite metallische Werkstoff des Mantels (6).

15. Verwendung zumindest eines Bondverbindungsmittels (2) zur Strommessung oder Temperaturermittlung in einem Halbleitermodul (8),
wobei das zumindest eine Bondverbindungsmittel (2) einen Kern (4) und einen den Kern (4), insbesondere vollständig, umhüllenden Mantel (6) aufweist,
wobei der Kern (4) aus einem ersten metallischen Werkstoff und der Mantel (6) aus einem vom ersten metallischen Werkstoff verschiedenen zweiten metallischen Werkstoff hergestellt ist und
wobei der erste metallische Werkstoff des Kerns (4) eine niedrigere elektrische Leitfähigkeit aufweist als der zweite metallische Werkstoff des Mantels (6).
